# EUROPÄISCHE PATENTSCHRIFT

(11) **EP 0 986 894 B1**
(45) Veröffentlichungstag und Bekanntmachung des Hinweises auf die Patenterteilung: **12.12.2001**
(21) Anmeldenummer: 98934807.3
(22) Anmeldetag: 27.05.1998
(51) Int. Cl.: H04N 1/40, G02B 5/00, H01S 3/00, G02B 17/00

(54) **VERFAHREN UND VORRICHTUNG ZUR BESEITIGUNG VON LICHT**
METHOD AND DEVICE FOR REMOVING LIGHT
PROCEDE ET DISPOSITIF DE SUPPRESSION DE LUMIERE

(30) Priorität: 03.06.1997 DE 19723170
(43) Veröffentlichungstag der Anmeldung: 22.03.2000
(73) Patentinhaber: Heidelberger Druckmaschinen Aktiengesellschaft, 69115 Heidelberg (DE)
(72) Erfinder: FISCHER, Jörg-Achim, D-24107 Kiel (DE); JACOBSEN, Thomas, D-24111 Kiel (DE)
(86) Internationale Anmeldenummer: DE9801446
(87) Internationale Veröffentlichungsnummer: WO9856165

(56) Entgegenhaltungen:
- EP-A- 0 533 346
- US-A- 4 747 673
- US-A- 5 457 567
- PATENT ABSTRACTS OF JAPAN vol. 013, no. 407 (E-818), 8. September 1989 & JP 01 146386 A (TOSHIBA CORP), 8. Juni 1989

## Beschreibung

Die Erfindung bezieht sich auf das Gebiet der elektronischen Reproduktionstechnik und betrifft ein Verfahren und eine Vorrichtung zur Beseitigung von Licht durch Absorption.

Das Verfahren und die Vorrichtung finden beispielsweise bei einem elektronischen Aufzeichnungsgerät zur punkt- und zeilenweisen Belichtung eines Aufzeichnungsmaterials mit einem Laserstrahl Anwendung.

In einem Aufzeichnungsgerät, auch Belichter oder Recorder genannt, wird ein durch ein Videosignal modulierter Laserstrahl punkt- und zeilenweise über ein zu belichtendes Aufzeichnungsmaterial geführt. Das Aufzeichnungsmaterial ist dabei auf einer Halterung fixiert, die sich relativ zum Lichtstrahl bewegt. Im Falle eines Innentrommel-Aufzeichnungsgerätes ist das Aufzeichnungsmaterial auf einer stationären zylindersegmentförmigen Halterung oder Belichtungsmulde fixiert, und der Laserstrahl wird mittels einer rotierenden Lichtstrahlablenk-Vorrichtung punkt- und zeilenweise über das Aufzeichnungsmaterial geführt. Das Aufzeichnungsgerät kann aber auch als Trommel-Gerät oder Flachbett-Gerät ausgebildet sein.

Zur Direktbelichtung von Druckplatten wird ein Laserstrahl mit einer hohen Lichtleistung benötigt, der in einer Laserlichtquelle, beispielsweise in Form eines YAG-Lasers, erzeugt wird. Die Modulation des Laserstrahls durch das Videosignal erfolgt in einem Videomodulator, der beispielsweise als akustooptischer Modulator (AOM) ausgebildet ist. Der akustooptische Modulator erzeugt aus dem EingangsLaserstrahl im wesentlichen einen benutzten Ausgangs-Laserstrahl 1. Ordnung, nachfolgend Belichtungsstrahl genannt, und einen nicht benutzten Ausgangs-Laserstrahl 0. Ordnung, nachfolgend Nebenstrahl genannt.

Während der Belichtungsstrahl mittels der rotierenden Lichtstrahlablenk-Vorrichtung punkt- und zeilenweise über das Aufzeichnungsmaterial geführt wird, muß der nicht gewünschte Nebenstrahl in einer Vorrichtung, Lichtsumpf oder einer Lichtfalle
(beam dump) genannt, absorbiert werden.

Ein ähnliches Problem besteht auch dann, wenn anstelle des Videomodulators ein gesteuerter Lichtstrahlablenker verwendet wird, welcher den zur Belichtung verwendeten Lichtstrahl in den Belichtungspausen in eine Lichtfalle ablenkt.

Um bei dem Aufzeichnungsgerät eine gute Aufzeichnungsqualität zu erzielen, müssen Rückreflexionen (back reflections) von Licht in die Laserlichtquelle vermieden werden, da sie zu störenden Schwingungen in der Laserlichtquelle anregen. Solche Rückreflexionen können direkt durch den nicht benutzten Nebenstrahl oder durch Reflexionen des Nebenstrahls an optischen Bauelementen und Gehäuseteilen als Streulicht verursacht werden, wenn die Lichtleistung des unerwünschten Nebenstrahls in der Lichtfalle nicht vollständig und gezielt abgeführt wird.

Aus der EP 0 533 346 A und der US 5,457,567 A sind bereits Laseraufzeichnungsgeräte bekannt, bei denen in einem akustooptischen Modulator (AOM) aus einem Eingangslaserstrahl ein zur Aufzeichnung benutzter Belichtungsstrahl und ein nicht benutzter Nebenstrahl erzeugt werden und bei denen der unerwünschte Nebenstrahl in einer Lichtfalle absorbiert wird. In den Druckschriften sind keine konkreten Ausführungsbeispiele für solche Lichtfallen angegeben.

Aus "Patent Abstracts of Japan, vol. 013, no. 407 (E-818), 8. September 1989 & JP 01 146386 A (TOSHIBA CORP), 8. Juni 1989" ist bereits eine Lichtfalle bekannt, die aus einem zylindrischen Hohlkörper, dessen eine Stirnseite die Lichteintrittsöffnung bildet, und aus einem achssymmetrisch angeordneten, konisch geformten Reflektor besteht.

Mit dieser bekannten Lichtfalle lassen sich Rückreflexionen in die Laserlichtquelle eines Laseraufzeichnungsgerätes aber nicht in ausreichendem Maße vermeiden, so daß die Aufzeichnungsqualität beeinträchtigt werden kann.

Aufgabe der vorliegenden Erfindung ist es daher, ein Verfahren und eine Vorrichtung zur Beseitigung von Licht durch Absorption vorzugsweise in einem elektronischen Aufzeichnungsgerät zur punkt- und zeilenweisen Belichtung eines Aufzeichnungsmaterials derart zu verbessern, daß störende Rückreflexionen in die Lichtquelle vermieden werden, um eine hohe Aufzeichnungsqualität zu erreichen.

Diese Aufgabe wird bezüglich des Verfahrens durch die Merkmale des Anspruchs 1 bzw. 9 und bezüglich der Vorrichtung durch die Merkmale des Anspruchs 4 bzw. 11 gelöst.
Vorteilhafte Weiterbildungen und Ausgestaltungen sind in den Unteransprüchen angegeben.

Die Erfindung wird nachfolgend anhand der Fig. 1 bis 3 näher erläutert.

Es zeigen:
- Fig. 1: ein prinzipielles Blockschaltbild eines elektronischen Aufzeichnungsgerätes mit einer Vorrichtung zur Lichtabsorption,
- Fig. 2: ein erstes Ausführungsbeispiel für eine Vorrichtung zur Lichtabsorption und
- Fig. 3: ein zweites Ausführungsbeispiel für eine Vorrichtung zur Lichtabsorption .

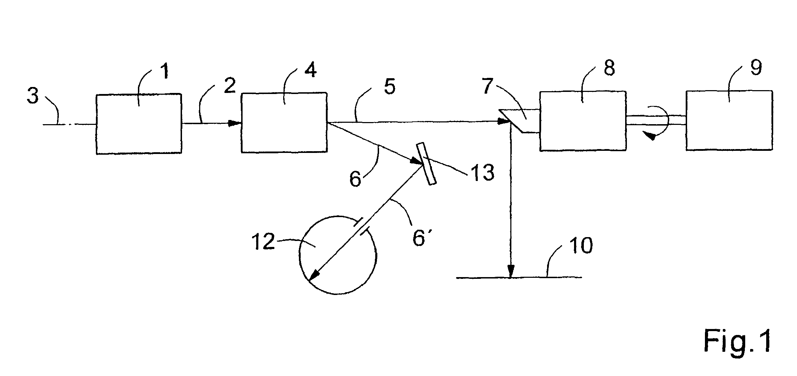

Fig. 1 zeigt den prinzipiellen Aufbau eines elektronischen Aufzeichnungsgerätes zum punkt- und zeilenweisen Belichten eines Aufzeichnungsmaterials. Eine Laserlichtquelle (1), beispielsweise ein YAG-Laser, zeugt einen Laserstrahl (2) entlang einer optischen Achse (3). Der Laserstrahl (2) trifft auf einen Videomodulator (4), der beispielsweise als akustooptischer Modulator ausgebildet ist. Wirkungsweise und Aufbau von akustooptischen Modulatoren (AOM) sind bekannt. Der Videomodulator (4) erzeugt aus dem Eigangs-Laserstrahl (2) im wesentlichen einen benutzen Ausgangs-Laserstrahl 1. Ordnung, nachfolgend Belichtungsstrahl (5) genannt, und einen nicht benutzten Ausgangs-Laserstrahl 0. Ordnung, nachfolgend Nebenstrahl (6) genannt.

Der aus dem Videomodulator (4) austretende Belichtungsstrahl (5) fällt auf einen schräg zur optischen Achse (3) orientierten Spiegel (7) einer Lichtstrahl-Ablenkvorrichtung (8), die sich mittels eines Rotationsantriebes (9) um die optische Achse (3) dreht. Die Lichtstrahl-Ablenkvorrichtung (8) lenkt den am Spiegel (7) reflektierten Belichtungsstrahl (5) in einer senkrecht zur Zeichenebene verlaufenden Ablenkebene punkt- und zeilenweise über ein zu belichtendes Aufzeichnungsmaterial (10) ab. Das Aufzeichnungsmaterial (10) ist im Fall eines Flachbett-Gerätes auf einer ebenen Halterung und im Fall eines Innentrommel-Gerätes an der Innenfläche einer stationären zylindersegmentförmigen Halterung oder Belichtungsmulde fixiert.

Ein zweipegliges Videosignal (V) auf einer Leitung (11) steuert den Videomodulator (4), welcher den Belichtungsstrahl (5), entsprechend der aufzuzeichnenden Information, ein- und ausschaltet.

Der nicht benutzte Nebenstrahl (6 ) wird zur Vermeidung von störenden Rückreflexionen in die Laserlichtquelle (1) in eine erfindungsgemäße Vorrichtung zur Lichtabsorption, kurz Lichtfalle (12) genannt, geleitet, die in Fig. 1 nur schematisch angedeutet ist.

Da der Nebenstrahl (6) und der Belichtungsstrahl (5) unter einem sehr kleinen Separationswinkel aus dem Videomodulator (4), wird der Nebenstrahl (6) aus Konstruktionsgründen in vorteilhafter Weise über einen Umlenkspiegel (13) in die Lichtfalle (12) geleitet. Um zu vermeiden, daß von dem Umlenkspiegel (13) selbst störende Rückreflexionen ausgehen, sollte der Umlenkspiegel (13) eine geringe Rautiefe aufweisen. Der Umlenkspiegel (13) ist daher beispielsweise als polierter Metallspiegel ausgebildet, der einen möglichst hohen Lichtanteil des Nebenstrahls (6) direkt in die Lichtfalle reflektiert und einen möglichst geringen Lichtanteil absorbiert oder als störendes Streulicht reflektiert.

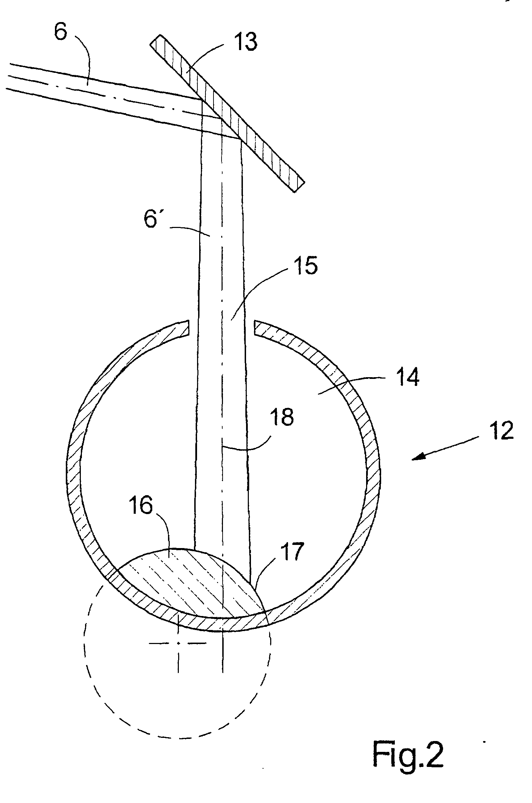

Fig. 2 zeigt ein erstes Ausführungsbeispiel für eine Lichtfalle im Schnittbild. Die Lichtfalle (12) besteht im wesentlichen aus einem Hohlkörper (14) mit einer Licht absorbierenden Innenfläche. Der Hohlkörper (14), beispielsweise in Form einer Hohlkugel, weist eine Lichteintrittsöffnung (15) auf, deren Position und Größe so groß gewählt sind, daß der von dem Umlenkspiegel (13) reflektierte Nebenstrahl (6') unge-hindert, d.h. ohne Entstehung von Streulicht in die Hohlkugel (14) eintritt. Beispielsweise ist der Durchmesser der kreisförmigen Lichteintrittsöffnung (15) mindestens doppelt so groß wie der Durchmesser 1/e² des Gaußschen Profils des durch die Lichteintrittsöffnung (15) durchtretenden Nebenstrahls (6').

An der Innenfläche der Hohlkugel (14), die der Lichteintrittsöffnung (15) abgewandt ist, befindet sich ein Reflektor (16), dessen Reflexionsfläche (17) der Lichteintrittsöffnung (15) der Hohlkugel (14) zugewandt ist. Die Reflexionsfläche (17) ist beispielsweise als polierte Metallfläche ausgebildet, damit wenig Streulicht entsteht.

Die Reflexionsfläche (17) ist in der Hohlkugel (14) derart positioniert und so groß gewählt, daß der durch die Lichteintrittsöffnung (15) einfallende Nebenstrahl (6') vollständig auf die Reflexionsfläche (17) fällt. Die Reflexionsfläche (17) ist derart gestaltet, daß der in die Hohlkugel (14) einfallende Nebenstrahl (6') an der Reflexionsfläche (17) nicht in sich reflektiert wird, daß ein möglichst geringer Lichtanteil des von der Reflexionsfläche (17) zurückgeworfenen Nebenstrahls (6') nicht durch die Lichteintrittsöffnung (15) der Hohlkugel (14) nach außen tritt und daß ein möglichst großer Lichtanteil des Nebenstrahls (6') auf die Innenfläche der Hohlkugel (14) trifft und dort direkt oder nach Mehrfachreflexionen an der Innenfläche absorbiert wird.

Der Reflektor (16) ist beispielsweise als Kugelabschnitt ausgebildet, dessen Oberfläche die Reflexionsfläche (17) bildet. Der Kugelabschnitt ist dann an der Innenfläche der Hohlkugel (14) angebracht. Alternativ kann der Reflektor (16) auch als Vollkugel ausgebildet sein, von der die Oberfläche eines entsprechenden Kugelabschnitts die Reflexionsfläche (17) bildet. In diesem Fall ragt die Vollkugel mit dem entsprechenden Kugelabschnitt in die Hohlkugel (14) hinein oder die Vollkugel wurde derart in die Innenfläche der Hohlkugel (14) gepreßt, daß nur der dem Kugelabschnitt entsprechende Teil der Vollkugel in die Hohlkugel (14) hineinragt.

Kugelabschnitt oder Vollkugel sind dann derart positioniert, daß der gedachte Mittelpunkt des Kugelabschnitts bzw. der Mittelpunkt der Vollkugel einen radialen Versatz gegenüber der optischen Achse (18) des Nebenstrahls (6') von einem Viertel des Kugelradius' aufweist, wobei der Kugelradius mindestens zweimal größer als der Durchmesser 1/e² des Gaußschen Profils des Nebenstrahls (6') gewählt ist.

In einem praktischen Ausführungsbeispiel wird die Hohlkugel (14) beispielsweise dadurch gebildet, daß zwei Werkstücke mit jeweils einer halbkugelförmigen Bohrung versehen werden und die Werkstücke dann derart zueinander angeordnet werden, daß sich die halbkugelförmigen Bohrungen zu der Hohlkugel (14) ergänzen, wobei eines der Werkstücke eine Bohrung aufweist, welche die Lichteintrittsöffnung (15) der Hohlkugel (14) bildet.

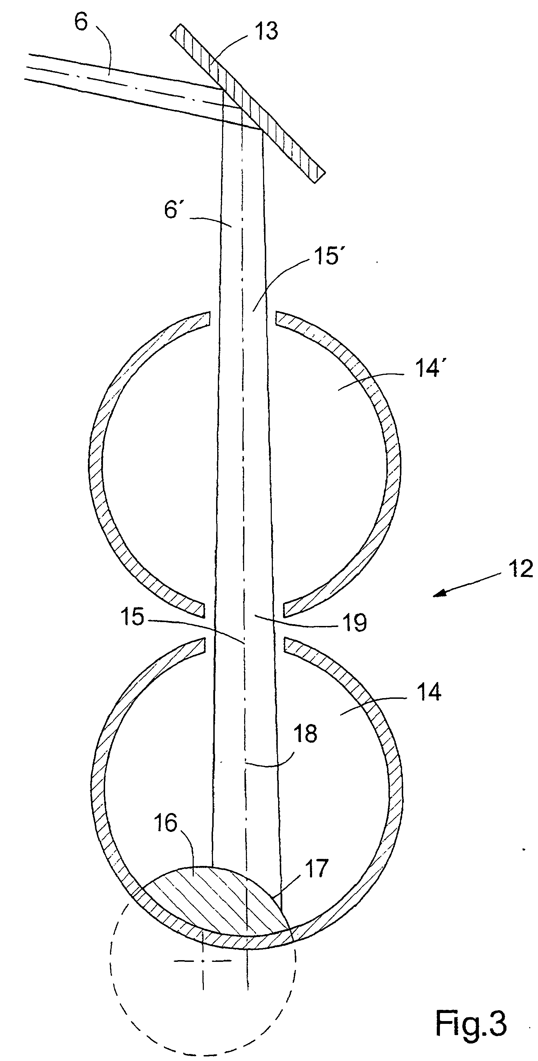

Fig. 3 zeigt ein zweites Ausführungsbeispiel für eine Lichtfalle. Falls dennoch geringfügiges Streulicht durch die Lichteintrittsöffnung (15) aus der Hohlkugel (14) austreten sollte, das störende Rückreflexionen in der Laserlichtquelle (1) verursacht, kann die Lichtfalle (12) erfindungsgemäß durch mindestens eine in Richtung des Umlenkspiegels (13) vorgeschaltete weitere Hohlkugel (14') ergänzt werden. Die vorgeschaltete Hohlkugel (14') weist eine Lichteintrittsöffnung (15') und eine Lichtaustrittsöffnung (19) auf, die unmittelbar über der Lichteintrittsfläche (15) der ersten Hohlkugel (14) angeordnet ist. Die vorgeschaltete Hohlkugel (14') sorgt erfindungsgemäß dafür, daß das aus der ersten Hohlkugel (14) gegebenenfalls noch austretende Streulicht in der vorgeschalteten zweiten Hohlkugel (14') in vorteilhafter Weise vollständig absorbiert wird. Die Durchmesser der Lichteintrittsöffnung (15') und die Lichtaustrittsöffnung (19) der vorgeschalteten Hohlkugel (14') sowie der Lichteintrittsöffnung (15) der ersten Hohlkugel (14) sind von der Divergenz des Nebenstrahls (6') abhängig.

## Patentansprüche

1. Verfahren zur Beseitigung von unerwünschtem Licht durch Absorption, bei dem
- Licht (6') durch eine Lichteintrittsöffnung (15) in einen Hohlkörper (14) mit einer lichtabsorbierenden Innenfläche geleitet wird und
- in den Hohlkörper (14) einfallendes Licht (6') mittels eines in dem Hohlkörper (14) befindlichen Reflektor (16) im wesentlichen auf die Innenfläche des Hohlkörpers (14) geleitet wird, **dadurch gekennzeichnet, daß**
- der Hohlkörper (14) mit der lichtabsorbierenden Innenfläche als Hohlkugel ausgebildet wird,
- die Lichteintrittsöffnung (15) der Hohlkugel (14) so groß gewählt wird, daß das unerwünschte, zu absorbierende Licht (6') ohne Lichtstreuung in die Hohlkugel (14) gelangt,
- die Reflexionsfläche (17) des Reflektors (16) mindestens als ein der Lichteintrittsöffnung (15) zugewandter Kugelabschnitt ausgebildet und auf der von der Lichteintrittsöffnung (15) abgewandten Innenfläche der Hohlkugel (14) angeordnet wird,
- die Reflexionsfläche (17) des Reflektors (16) derart innerhalb der Hohlkugel (14) positioniert wird, daß
- das durch die Lichteintrittsöffnung (15) einfallende und von der Reflexionsfläche (17) zurückgeworfene Licht nicht in sich selbst reflektiert wird,
- ein möglichst geringer Anteil des zurückgeworfenen Lichts nicht als Streulicht durch die Lichteintrittsöffnung (15) nach außen gelangt und
- ein möglichst großer Anteil des zurückgeworfenen Lichts von der Innenfläche der Hohlkugel (14) absorbiert wird.

2. Verfahren nach Anspruch 1, **dadurch gekennzeichnet, daß**
- mindestens eine weitere Hohlkugel (14') mit einer Lichteintrittsöffnung (15'), einer der Lichteintrittsöffnung (15') diametral gegenüberliegenden Lichtaustrittsöffnung (19) und mit einer lichtabsorbierenden Innenfläche vorgesehen wird,
- die weitere Hohlkugel (14') derart vor der ersten Hohlkugel (14) mit der Lichteintrittsöffnung (15) und dem Reflektor (16) angeordnet wird, daß
- die Lichtaustrittsöffnung (19) der weiteren Hohlkugel (14') vor der Lichteintrittsöffnung (15) der ersten Hohlkugel liegt,
- das unerwünschte Licht (6') durch die Lichteintrittsöffnung (15') und die Lichtaustrittsöffnung (19) der weiteren Hohlkugel (14') in die erste Hohlkugel (14) eintritt und dort absorbiert wird und
- das gegebenenfalls durch die Lichteintrittsfläche (15) der ersten Hohlkugel (14) austretende Streulicht an der absorbierenden Innenfläche der weiteren Hohlkugel (14') vollständig beseitigt wird.

3. Verfahren nach Anspruch 1oder 2, **dadurch gekennzeichnet, daß** das unerwünschte Licht (6') Laserlicht ist.

4. Vorrichtung zur Beseitigung von unerwünschtem Licht durch Absorption, bestehend aus
- einem Hohlkörper (14) mit einer lichtabsorbierenden Innenfläche und einer Lichteintrittsöffnung (15) für das unerwünschte Licht (6') und
- einem in dem Hohlkörper (14) befindlichen Reflektor (16), welcher in den Hohlkörper (14) einfallendes Licht (6') im wesentlichen auf die Innenfläche des Hohlkörpers (14) leitet, **dadurch gekennzeichnet, daß**
- der Hohlkörper (14) mit der lichtabsorbierenden Innenfläche als Hohlkugel ausgebildet ist,
- die Lichteintrittsöffnung (15) der Hohlkugel (14) so groß gewählt ist, daß das unerwünschte, zu absorbierende Licht (6') ohne Lichtstreuung in die Hohlkugel (14) gelangt,
- die Reflexionsfläche (17) des Reflektors (16) mindestens als ein der Lichteintrittsöffnung (15) zugewandter Kugelabschnitt ausgebildet und auf der von der Lichteintrittsöffnung (15) abgewandten Innenfläche der Hohlkugel (14) angeordnet ist und
- die Reflexionsfläche (17) des Reflektors (16) derart innerhalb der Hohlkugel (14) positioniert ist, daß das durch die Lichteintrittsöffnung (15) einfallende und von der Reflexionsfläche (17) zurückgeworfene Licht nicht in sich selbst reflektiert wird, ein möglichst geringer Anteil des zurückgeworfenen Lichts nicht als Streulicht durch die Lichteintrittsöffnung (15) nach außen gelangt und ein möglichst großer Anteil des zurückgeworfenen Lichts von der Innenfläche der Hohlkugel (14) absorbiert wird.

5. Vorrichtung nach Anspruch 4, **dadurch gekennzeichnet, daß**
- mindestens eine weitere Hohlkugel (14') mit einer Lichteintrittsöffnung (15'), einer der Lichteintrittsöffnung (15') diametral gegenüberliegenden Lichtaustrittsöffnung (19) und mit einer lichtabsorbierenden Innenfläche vorgesehen ist und
- die weitere Hohlkugel (14') derart vor der ersten Hohlkugel (14) mit der Lichteintrittsöffnung (15) und dem Reflektor (16) angeordnet wird, daß die Lichtaustrittsöffnung (19) der weiteren Hohlkugel (14') vor der Lichteintrittsöffnung (15) der ersten Hohlkugel liegt, das unerwünschte Licht (6') durch die Lichteintrittsöffnung (15') und die Lichtaustrittsöffnung (19) der weiteren Hohlkugel (14') in die erste Hohlkugel (14) eintritt und absorbiert wird und das gegebenenfalls durch die Lichteintrittsfläche (15) der ersten Hohlkugel (14) austretende Streulicht an der absorbierenden Innenfläche der weiteren Hohlkugel (14') vollständig beseitigt wird.

6. Vorrichtung nach Anspruch 4, **dadurch gekennzeichnet, daß**
- der Reflektor (16) als Kugelabschnitt ausgebildet ist und
- der Reflektor (16) an der Innenfläche des Hohlkörpers (14) angebracht ist.

7. Vorrichtung nach Anspruch 4, **dadurch gekennzeichnet, daß**
- der Reflektor (16) als Vollkugel ausgebildet ist, von der ein Kugelabschnitt die Reflexionsfläche (17) bildet und
- der die Reflexionsfläche (17) bildende Kugelabschnitt in die Hohlkugel (14) hineinragt.

8. Vorrichtung nach Anspruch 4, **dadurch gekennzeichnet, daß**
- der Reflektor (16) als Vollkugel ausgebildet ist, von der ein Kugelabschnitt die Reflexionsfläche (17) bildet und
- die Vollkugel derart in die Innenfläche die Hohlkugel (14) gepreßt ist, daß nur der dem Kugelabschnitt entsprechende Teil der Vollkugel in die Hohlkugel (14) hineinragt.

9. Verfahren zur Beseitigung von Laserlicht durch Absorption in einem elektronischen Aufzeichnungsgerät zur punkt- und zeilenweisen Belichtung eines Aufzeichnungsmaterials mit einem Belichtungsstrahl, bei dem
- ein Laserstrahl (2) in einer Laserlichtquelle (1) erzeugt wird,
- der Laserstrahl (2) in einem akustooptischen Modulator (4) moduliert wird, wobei der Laserstrahl (2) im wesentlichen in den Belichtungsstrahl (5) zur Belichtung des Aufzeichnungsmaterials und in einen unerwünschten Nebenstrahl (6') aufgespalten wird und
- der unerwünschte Nebenstrahl (6') mittels eines Absorptionselements (12) beseitigt wird, **dadurch gekennzeichnet, daß** zur Vermeidung von Rückreflexionen in die Laserlichtquelle (1)
- der Nebenstrahl (6') durch eine Lichteintrittsöffnung (15) in eine Hohlkugei (14) als Absorptionselement mit einer lichtabsorbierenden Innenfläche geleitet wird,
- die Lichteintrittsöffnung (15) der Hohlkugel (14) so groß gewählt wird, daß der Nebenstrahl (6') ohne Lichtstreuung in die Hohlkugel (14) gelangt,
- der in die Hohlkugel (14) geleitete Nebenstrahl (6') auf eine an der von der Lichteintrittsöffnung (15) abgewandten Innenfläche der Hohlkugel (14) angeordnete Reflexionsfläche (17) eines Reflektors (16) fällt, welche mindestens als ein Kugelabschnitt ausgebildet ist,
- die als Kugelabschnitt ausgebildete Reflexionsfläche (17) des Reflektors (16) derart innerhalb der Hohlkugel (14) positioniert wird, daß
- der durch die Lichteintrittsöffnung (15) einfallende und von der Reflexionsfläche (17) zurückgeworfene Nebenstrahl (6') nicht in sich selbst reflektiert wird,
- ein möglichst geringer Anteil des zurückgeworfenen Nebenstrahls (6') nicht als Streulicht durch die Lichteintrittsöffnung (15) nach außen gelangt und
- ein möglichst großer Anteil des zurückgeworfenen Nebenstrahls (6') von der Innenfläche der Hohlkugel (14) absorbiert wird.

10. Verfahren nach Anspruch 9, **dadurch gekennzeichnet, daß**
- mindestens eine weitere Hohlkugel (14') mit einer Lichteintrittsöffnung (15'), einer der Lichteintrittsöffnung (15') diametral gegenüberliegenden Lichtaustrittsöffnung (19) und mit einer lichtabsorbierenden Innenfläche vorgesehen wird,
- die weitere Hohlkugel (14') derart vor der ersten Hohlkugel (14) mit der Lichteintrittsöffnung (15) und dem Reflektor (16) angeordnet wird, daß
- die Lichtaustrittsöffnung (19) der weiteren Hohlkugel (14') vor der Lichteintrittsöffnung (15) der ersten Hohlkugel (14) liegt,
- der Nebenstrahl (6') durch die Lichteintrittsöffnung (15') und die Lichtaustrittsöffnung (19) der weiteren Hohlkugel (14') in die erste Hohlkugel (14) eintritt und
- das gegebenenfalls durch die Lichteintrittsöffnung (15) der ersten Hohlkugel (14) austretende Streulicht von der Innenfläche der weiteren Hohikugel (14') vollständig absorbiert wird.

11. Vorrichtung zur Beseitigung von Laserlicht in einem elektronischen Aufzeichnungsgerät zur punkt- und zeilenweisen Belichtung eines Aufzeichnungsmaterials mit einem Belichtungsstrahl, bestehend aus
- einem Lasergenerator (1) zur Erzeugung eines Laserstrahls (2),
- einem akustooptischen Modulator (4) zur Modulation des Laserstrahls, wobei der Modulator (4) den Laserstrahl (2) im wesentlichen in den Belichtungsstrahl (5) und einen unerwünschten Nebenstrahl (6') aufspaltet und
- einem Absorptionselement (12) zur Beseitigung des unerwünschten Nebenstrahls (6'), **dadurch gekennzeichnet, daß**
- das Absorptionselement (12) als Hohlkugel (14) mit einer Lichteintrittsöffnung (15) für den Nebenstrahl (6') und einer lichtabsorbierenden Innenfläche ausgebildet ist,
- an der der Lichteintrittsöffnung (15) gegenüberliegenden Innenfläche der Hohlkugel (14) ein Reflektor (16) mit einer der Lichteintrittsöffnung (15) zugewandten und als mindestens ein Kugelabschnitt ausgebildeten Reflexionsfläche (17) zur Reflexion des durch die Lichteintrittsöffnung (15) einfallenden Nebenstrahls (6') angeordnet ist und
- die als Kugelabschnitt ausgebildete Reflexionsfläche (17) derart gestaltet und in der Hohlkugel (14) positioniert ist, daß der von der Reflexionsfläche (17) zurückgeworfene Nebenstrahl (6') nicht in sich selbst reflektiert wird, ein möglichst geringer Anteil des zurückgeworfenen Nebenstrahls (6') nicht als Streulicht durch die Lichteintrittsöffnung (15) nach außen gelangt und ein möglichst großer Anteil des zurückgeworfenen Nebenstrahls (6') auf die Innenfläche der Hohlkugel (14) gelangt und dort absorbiert wird.

12. Vorrichtung nach Anspruch 11, **dadurch gekennzeichnet, daß**
- mindestens eine weitere Hohlkugel (14') mit einer Lichteintrittsöffnung (15'), einer der Lichteintrittsöffnung (15') diametral gegenüberliegenden Lichtaustrittsöffnung (19) und mit einer lichtabsorbierenden Innenfläche vorgesehen ist und
- die weitere Hohlkugel (14') derart vor der ersten Hohlkugel (14) mit der Lichteintrittsöffnung (15) und dem Reflektor (16) angeordnet wird, daß die Lichtaustrittsöffnung (19) der weiteren Hohlkugel (14') vor der Lichteintrittsöffnung (15) der ersten Hohlkugel (14) liegt, der Nebenstrahl (6') durch die Lichteintrittsöffnung (15') und die Lichtaustrittsöffnung (19) der weiteren Hohlkugel (14') in die erste Hohlkugel (14) eintritt und das gegebenenfalls durch die Lichteintrittsfläche (15) der ersten Hohlkugel (14) austretende Streulicht von der Innenfläche der weiteren Hohlkugel (14') vollständig absorbiert wird.

## Claims

1. Method for eliminating undesired light by absorption, in which
- light (6') is directed through a light entry port (15) into a hollow body (14) with a light-absorbing internal surface, and
- light (6') entering the hollow body (14) is directed substantially on to the internal surface of the hollow body (14) by means of a reflector (16) located inside the hollow body (14), **characterized in that**
- the hollow body (14) with the light-absorbing internal surface is configured as a hollow sphere,
- the light entry port (15) of the hollow sphere (14) is made sufficiently large for the undesired light (6') which is to be absorbed to pass into the hollow sphere (14) without scattering,
- the reflecting surface (17) of the reflector (16) is configured as at least a segment of a sphere facing towards the light entry port (15) and is arranged on the opposite internal surface of the hollow sphere (14) to the light entry port (15),
- the reflecting surface (17) of the reflector (16) is positioned within the hollow sphere (14) in such a way that
- the light entering through the light entry port (15) and reflected by the reflecting surface (17) is not reflected back on itself,
- the smallest possible fraction of the reflected light escapes through the light entry port (15) not as scattered light, and
- the largest possible fraction of the reflected light is absorbed by the internal surface of the hollow sphere (14).

2. Method according to Claim 1, **characterized in that**
- at least one additional hollow sphere (14') with a light entry port (15'), a light exit port (19) diametrically opposite the light entry port (15'), and a light-absorbing internal surface, is provided,
- the additional hollow sphere (14') is arranged in front of the first hollow sphere (14) with the light entry port (15) and reflector (16) in such a way that
- the light exit port (19) of the additional hollow sphere (14') lies in front of the light entry port (15) of the first hollow sphere,
- the undesired light (6') passes through the light entry port (15') and light exit port (19) of the additional hollow sphere (14') into the first hollow sphere (14), where it is absorbed, and
- any scattered light escaping through the light entry [port] (15) of the first hollow sphere (14) is completely eliminated at the absorbing internal surface of the additional hollow sphere (14').

3. Method according to Claim 1 or 2, **characterized in that** the undesired light (6') is laser light.

4. Apparatus for eliminating undesired light by absorption, comprising
- a hollow body (14) with a light-absorbing internal surface and a light entry port (15) for the undesired light (6') and
- a reflector (16) located inside the hollow body (14), which directs light (6') entering the hollow body (14) substantially on to the internal surface of the hollow body (14), **characterized in that**
- the hollow body (14) with the light-absorbing internal surface is configured as a hollow sphere,
- the light entry port (15) of the hollow sphere (14) is made sufficiently large for the undesired light (6') which is to be absorbed to pass into the hollow sphere (14) without scattering,
- the reflecting surface (17) of the reflector (16) is configured as at least a segment of a sphere facing towards the light entry port (15) and is arranged on the opposite internal surface of the hollow sphere (14) to the light entry port (15),
- the reflecting surface (17) of the reflector (16) is positioned within the hollow sphere (14) in such a way that the light entering through the light entry port (15) and reflected by the reflecting surface (17) is not reflected back on itself, the smallest possible fraction of the reflected light escapes through the light entry port (15) not as scattered light, and the largest possible fraction of the reflected light is absorbed by the internal surface of the hollow sphere (14).

5. Apparatus according to Claim 4, **characterized in that**
- at least one additional hollow sphere (14') with a light entry port (15'), a light exit port (19) diametrically opposite the light entry port (15'), and a light-absorbing internal surface, is provided, and
- the additional hollow sphere (14') is arranged in front of the first hollow sphere (14) with the light entry port (15) and reflector (16) in such a way that the light exit port (19) of the additional hollow sphere (14') lies in front of the light entry port (15) of the first hollow sphere, the undesired light (6') passes through the light entry port (15') and light exit port (19) of the additional hollow sphere (14') into the first hollow sphere (14) and is absorbed, and any scattered light escaping through the light entry [port] (15) of the first hollow sphere (14) is completely eliminated at the absorbing internal surface of the additional hollow sphere (14').

6. Apparatus according to Claim 4, **characterized in that**
- the reflector (16) is configured as a segment of a sphere, and
- the reflector (16) is attached to the internal surface of the hollow body (14).

7. Apparatus according to Claim 4, **characterized in that**
- the reflector (16) is configured as a full sphere of which one segment forms the reflecting surface (17), and
- the spherical segment forming the reflecting surface (17) projects into the hollow sphere (14).

8. Apparatus according to Claim 4, **characterized in that**
- the reflector (16) is configured as a full sphere of which one segment forms the reflecting surface (17), and
- the full sphere is pressed into the internal surface [of] the hollow sphere (14) so that only the part of the full sphere which corresponds to the spherical segment projects into the hollow sphere (14).

9. Method for eliminating laser light by absorption in an electronic recording apparatus for point-by-point and line-by-line exposure of a recording material with an exposure beam, in which
- a laser beam (2) is generated in a laser light source (1),
- the laser beam (2) is modulated in an acousto-optic modulator (4), the laser beam (2) essentially being split into the exposure beam (5) for the exposure of the recording material and an undesired secondary beam (6'), and
- the undesired secondary beam (6') is eliminated by means of an absorption element (12), **characterized in that** in order to prevent back-reflections into the laser light source (1)
- the secondary beam (6') is directed through a light entry port (15) into a hollow sphere (14) as absorption element with a light-absorbing internal surface,
- the light entry port (15) of the hollow sphere (14) is made sufficiently large for the secondary beam (6') to pass into the hollow sphere (14) without scattering,
- the secondary beam (6') directed into the hollow sphere (14) falls on to a reflecting surface (17) of a reflector (16) which is configured as at least a segment of a sphere and is arranged on the opposite internal surface of the hollow sphere (14) to the light entry port (15),
- the reflecting surface (17) of the reflector (16) configured as a segment of a sphere is positioned within the hollow sphere (14) in such a way that
- the secondary beam (6') entering through the light entry port (15) and reflected by the reflecting surface (17) is not reflected back on itself,
- the smallest possible fraction of the reflected secondary beam (6') escapes through the light entry port (15) not as scattered light, and
- the largest possible fraction of the reflected secondary beam (6') is absorbed by the internal surface of the hollow sphere (14).

10. Method according to Claim 9, **characterized in that**
- at least one additional hollow sphere (14') with a light entry port (15'), a light exit port (19) diametrically opposite the light entry port (15'), and a light-absorbing internal surface, is provided, [and]
- the additional hollow sphere (14') is arranged in front of the first hollow sphere (14) with the light entry port (15) and reflector (16) in such a way that
- the light exit port (19) of the additional hollow sphere (14') lies in front of the light entry port (15) of the first hollow sphere (14),
- the secondary beam (6') passes through the light entry port (15') and light exit port (19) of the additional hollow sphere (14') into the first hollow sphere (14), and
- any scattered light escaping through the light entry port (15) of the first hollow sphere (14) is completely absorbed by the internal surface of the additional hollow sphere (14').

11. Apparatus for eliminating laser light in an electronic recording apparatus for point-by-point and line-by-line exposure of a recording material with an exposure beam, comprising
- a laser generator (1) for generating a laser beam (2),
- an acousto-optic modulator (4) for modulating the laser beam, the modulator (4) splitting the laser beam (2) essentially into the exposure beam (5) and an undesired secondary beam (6'), and
- an absorption element (12) for eliminating the undesired secondary beam (6'), **characterized in that**
- the absorption element (12) is configured as a hollow sphere (14) with a light entry port (15) for the secondary beam (6') and a light-absorbing internal surface,
- a reflector (16) with a reflecting surface (17) facing the light entry port (15) and configured as at least a segment of a sphere is arranged on the opposite internal surface of the hollow sphere (14) to the light entry port (15) to reflect the secondary beam (6') entering through the light entry port (15), and
- the reflecting surface (17) configured as a segment of a sphere is formed and positioned within the hollow sphere (14) in such a way that the secondary beam (6') reflected by the reflecting surface (17) is not reflected back on itself, the smallest possible fraction of the reflected secondary beam (6') escapes through the light entry port (15) not as scattered light, and the largest possible fraction of the reflected secondary beam (6') impinges on the internal surface of the hollow sphere (14), where it is absorbed.

12. Apparatus according to Claim 11, **characterized in that**
- at least one additional hollow sphere (14') with a light entry port (15'), a light exit port (19) diametrically opposite the light entry port (15'), and a light-absorbing internal surface, is provided, and
- the additional hollow sphere (14') is arranged in front of the first hollow sphere (14) with the light entry port (15) and reflector (16) in such a way that the light exit port (19) of the additional hollow sphere (14') lies in front of the light entry port (15) of the first hollow sphere (14), the secondary beam (6') passes through the light entry port (15') and light exit port (19) of the additional hollow sphere (14') into the first hollow sphere (14), and any scattered light escaping through the light entry port (15) of the first hollow sphere (14) is completely absorbed by the internal surface of the additional hollow sphere (14').

## Revendications

1. Procédé pour éliminer par absorption de la lumière gênante selon lequel :
- on conduit la lumière (6') à travers un orifice d'entrée de lumière (15) dans un corps creux (14) dont la surface intérieure absorbe la lumière, et
- on guide la lumière (6') incidente dans le corps creux (14) à l'aide d'un réflecteur (16) qui se trouve dans le corps creux (14), essentiellement sur la surface intérieure du corps creux (14),
**caractérisé en ce qu'**
- on réalise le corps creux (14) dont la surface intérieure absorbe la lumière sous la forme d'une sphère creuse,
- on choisit la dimension de l'orifice d'entrée de la lumière (15) dans la sphère creuse (14) pour que la lumière à absorber (6'), gênante, arrive dans la sphère creuse (14) sans diffraction,
- la surface réfléchissante (17) du réflecteur (16) est réalisée au moins sous la forme d'un segment de sphère tourné vers l'orifice d'entrée de lumière (15) et cette surface est prévue sur la surface intérieure de la sphère creuse (14) à l'opposé de l'orifice d'entrée de lumière (15),
- la surface de réflexion (17) du réflecteur (16) est positionnée à l'intérieur de la sphère creuse (14) pour que,
- la lumière incidente par l'orifice d'entrée de lumière (15) et renvoyée par la surface réfléchissante (17) ne se réfléchit pas elle-même,
- une fraction aussi réduite que possible de la lumière renvoyée arrive à l'extérieur sous la forme de lumière dispersée traversant l'orifice d'entrée de lumière (15), et
- on absorbe une fraction aussi grande que possible de la lumière renvoyée à l'aide de la surface intérieure de la sphère creuse (14).

2. Procédé selon la revendication 1,
**caractérisé par**
- au moins une autre sphère creuse (14') avec un orifice d'entrée de lumière (15') prévu diamétralement opposé à l'orifice de sortie de lumière (19) et comportant une surface intérieure absorbant la lumière,
- l'autre sphère creuse (14') est disposée par rapport à la première sphère creuse (14) avec l'orifice d'entrée de lumière (15) et le réflecteur (16) pour que,
- l'orifice de sortie de lumière (19) de l'autre sphère creuse (14') se situe devant l'orifice d'entrée de lumière (15) de la première sphère creuse,
- la lumière non voulue (6') arrive par l'orifice d'entrée de lumière (15') et pénètre par l'orifice de sortie de lumière (19) de l'autre sphère creuse (14') pour arriver dans la première sphère creuse primaire (14) et y être absorbée, et
- l'éventuelle lumière dispersée sortant par la surface d'entrée de lumière (15) de la première sphère creuse (14) est complètement éliminée par la surface intérieure absorbante de l'autre sphère creuse (14').

3. Procédé selon la revendication 1 ou 2,
**caractérisé en ce que**
la lumière (6') gênante est de la lumière laser.

4. Dispositif pour éliminer de la lumière gênante par absorption, comprenant :
- un corps creux (14) avec une surface intérieure absorbant la lumière et un orifice d'entrée de lumière (15) pour recevoir la lumière non voulue (6'),
- un réflecteur (16) placé dans le corps creux (14) qui dirige la lumière incidente (6') dans le corps creux (14) essentiellement vers la surface intérieure du corps creux (14),
- **caractérisé en ce que**
- le corps creux (14) est une sphère creuse dont la surface intérieure absorbe la lumière,
- l'orifice d'entrée de la lumière (15) de la sphère creuse (14) est choisi suffisamment grand pour que la lumière (6') non voulue, que l'on veut absorber, arrive dans la sphère creuse (14) sans diffraction ou dispersion de lumière,
- la surface réfléchissante (17) du réflecteur (16) est réalisée au moins sous la forme d'un segment de sphère tourné vers l'orifice d'entrée de lumière (15) et ce segment de sphère est prévu sur la surface intérieure de la sphère creuse (14), à l'opposé de l'orifice d'entrée de lumière (15), et
- la surface réfléchissante (17) du réflecteur (16) est positionnée à l'intérieur de la sphère creuse (14) pour que la lumière incidente pénétrant par l'orifice d'entrée de lumière (15) et renvoyée par la surface réfléchissante (17) ne se réfléchisse pas d'elle-même et qu'une fraction aussi réduite que possible de la lumière renvoyée ne sorte pas comme lumière dispersée par l'orifice d'entrée de lumière (15) et qu'une fraction aussi grande que possible de la lumière renvoyée soit absorbée par la surface intérieure de la sphère creuse (14).

5. Dispositif selon la revendication 4,
**caractérisé en ce qu'**
- au moins une autre sphère creuse (14') munie d'un orifice d'entrée de lumière (15') et d'un orifice de sortie de lumière (19) diamétralement opposé à l'orifice d'entrée de lumière (15') et comportant une surface intérieure absorbant la lumière, et
- cette autre sphère creuse (14') est placée devant la première sphère creuse (14) avec l'orifice d'entrée de lumière (15) et le réflecteur (16) pour que l'orifice de sortie de lumière (19) de l'autre sphère creuse (14') se trouve devant l'orifice d'entrée de lumière (15) de la première sphère creuse et que la lumière non voulue (6') passe par l'orifice d'entrée de lumière (15') et l'orifice de sortie de lumière (19) de l'autre sphère creuse (14') pour arriver dans la première sphère creuse (14) et y être absorbée et le cas échéant la lumière dispersée sortant de la surface d'entrée de lumière (15) de la première sphère creuse (14) est complètement éliminée par la surface intérieure absorbante de l'autre sphère creuse (14').

6. Dispositif selon la revendication 4,
**caractérisé en ce que**
- le réflecteur (16) est un segment de sphère, et
- le réflecteur (16) est installé contre la surface intérieure du corps creux (14).

7. Dispositif selon la revendication 4,
**caractérisé en ce que**
- le réflecteur (16) est une sphère pleine dont un segment de sphère forme la surface réfléchissante (17), et
- le segment de sphère formant la surface réfléchissante (17) pénètre dans la sphère creuse (14).

8. Dispositif selon la revendication 4,
**caractérisé en ce que**
- le réflecteur (14) est une sphère pleine dont un segment forme la surface réfléchissante (17) et la sphère pleine est pressée contre la surface intérieure de la sphère creuse (14) pour que seulement la partie de la sphère creuse correspondant au segment de sphère pénètre dans la sphère creuse (14).

9. Procédé pour éliminer la lumière laser par absorption dans un appareil d'enregistrement électronique pour l'exposition point par point et ligne par ligne d'une matière d'enregistrement avec un rayon lumineux, selon lequel,
- on génère un faisceau laser (2) dans une source de lumière laser (1),
- on module le faisceau laser (2) avec un modulateur acousto-optique (4), le faisceau laser (2) étant divisé essentiellement en un faisceau d'exposition (5) pour exposer un support d'enregistrement et un faisceau auxiliaire (6') non voulu, et
- on élimine le faisceau auxiliaire (6') non voulu à l'aide d'un élément absorbant (12),
**caractérisé en ce que**
pour éviter les réflexions en retour dans la surface de lumière laser (1),
- le faisceau auxiliaire (6') est conduit à travers un orifice d'entrée de lumière (15) dans une sphère creuse (14) comme élément absorbant ayant une surface intérieure absorbant la lumière,
- l'orifice d'entrée de lumière (15) de la sphère creuse (14) est choisi suffisamment grand pour que le faisceau auxiliaire (6') arrive dans la sphère creuse (14) sans être dispersé,
- le faisceau auxiliaire (6') conduit dans la sphère creuse (14) tombe sur une surface réfléchissante (17) d'un réflecteur (16) prévu sur la surface intérieure de la sphère creuse (14) à l'opposé de l'orifice d'entrée de lumière (15), la surface réfléchissante étant au moins un segment de sphère,
- la surface réfléchissante (17) du réflecteur (16) réalisée sous la forme d'un segment de sphère est positionnée à l'intérieur de la sphère creuse (14) pour que,
- le faisceau auxiliaire (6') arrivant par l'orifice d'entrée de lumière (15) et qui est renvoyé par la surface réfléchissante (17) ne soit pas réfléchi automatiquement,
- une fraction aussi faible que possible du faisceau auxiliaire (6') renvoyé n'arrive pas à l'extérieur sous forme de lumière dispersée traversant l'orifice d'entrée de lumière (15), et
- un nombre aussi grand que possible du faisceau auxiliaire (6'), renvoyé, est absorbé par la surface intérieure de la sphère creuse (14).

10. Procédé selon la revendication 9,
**caractérisé en ce qu'**
- au moins une autre sphère creuse (14') avec un orifice d'entrée de lumière (15') et un orifice de sortie de lumière (19) diamétralement opposé à l'orifice d 'entrée de lumière (15') et une surface intérieure absorbant la lumière,
- l'autre sphère creuse (14') est placée devant la première sphère creuse (14) avec son orifice d'entrée de lumière (15) et le réflecteur (16),
- l'orifice de sortie de lumière (19) de l'autre sphère creuse (14') est situé devant l'orifice d'entrée de lumière (15) de la première sphère creuse (14),
- le faisceau auxiliaire (6') arrive par l'orifice d'entrée de lumière (15') et l'orifice de sortie de lumière (19) de l'autre sphère creuse (14') dans la première sphère creuse (14), et
- la lumière dispersée sortant le cas échéant par l'orifice d'entrée de lumière (15) de la première sphère creuse (14) est absorbée complètement par la surface intérieure de l'autre sphère creuse (14').

11. Dispositif pour éliminer la lumière laser d'un appareil d'enregistrement électronique pour l'exposition point par point et ligne par ligne d'un support d'enregistrement avec un faisceau laser d'exposition comprenant :
- un générateur laser (1) générant un faisceau laser (2),
- un modulateur acousto-optique (4) pour moduler le faisceau laser, le modulateur (4) divisant le faisceau laser (2) principalement en un faisceau d'éclairage (5) et un faisceau auxiliaire (6') non voulu, et
- un élément absorbant (12) élimine le faisceau auxiliaire non voulu (6'),
**caractérisé en ce que**
- l'élément absorbant (12) est réalisé sous la forme d'une sphère creuse (14) avec un orifice d'entrée de lumière (15) pour le faisceau auxiliaire (6') et une surface intérieure absorbant la lumière,
- la surface intérieure opposée à l'orifice d'entrée de lumière (15) de la sphère creuse (14) comporte un réflecteur (16) avec une surface réfléchissante (17) tournée vers l'orifice d'entrée de lumière (15) et qui est réalisée au moins sous la forme d'un segment de sphère pour réfléchir le faisceau auxiliaire (6') incident arrivant par l'orifice d'entrée de lumière (15), et
- la surface réfléchissante (17) réalisée sous la forme d'un segment de sphère est positionnée dans la sphère creuse (14) pour que le faisceau auxiliaire (6') renvoyé par la surface réfléchissante (17) ne se réfléchisse pas de lui-même et qu'une fraction aussi faible que possible du faisceau auxiliaire renvoyé (6') ne sorte pas sous la forme de lumière dispersée en passant par l'orifice d'entrée de lumière (15) et qu'une fraction aussi grande que possible du faisceau auxiliaire renvoyé (6') arrive sur la surface intérieure de la sphère creuse (14) pour y être absorbée.

12. Dispositif selon la revendication 11,
**caractérisé en ce que**
- au moins une autre sphère creuse (14') avec un orifice d'entrée de lumière (15') est prévue de façon que l'orifice d'entrée de lumière (15') soit diamétralement opposé à l'orifice de sortie de lumière (19) et cette sphère présente une surface intérieure absorbant la lumière, et
- l'autre sphère creuse (14') est placée devant la première sphère creuse (14) avec son orifice d'entrée de lumière (15) et le réflecteur (16) pour que l'orifice de sortie de lumière (17) de l'autre sphère creuse (14') se trouve devant l'orifice d'entrée de lumière (15) de la première sphère creuse (14) et que le faisceau auxiliaire (6') passant par l'orifice d'entrée de lumière (15') et l'orifice de sortie de lumière (19) de l'autre sphère creuse (14') pénètre dans la première sphère creuse (14) et que le cas échéant la lumière dispersée sortant par la surface d'entrée de lumière (15) de la première sphère creuse (14) est absorbée complètement par la surface intérieure de l'autre sphère creuse (14').
